# EUROPEAN PATENT APPLICATION

(11) **EP 4 626 201 A1**
(43) Date of publication of application: **01.10.2025**
(21) Application number: 25158530.3
(22) Date of filing: 18.02.2025
(51) Int. Cl.: H10K 59/80

(54) **DISPLAY DEVICE**

(30) Priority: 26.03.2024 KR 20240041003
(71) Applicant: Samsung Display Co., Ltd., Yongin-si, Gyeonggi-do 17113 (KR)
(72) Inventor: Onoue, Shinya, Yongin-si, Gyeonggi-do (KR); Kim, Eunki, Yongin-si, Gyeonggi-do (KR); Mun, Eunjoong, Yongin-si, Gyeonggi-do (KR); Hwang, Hyeon Deuk, Yongin-si, Gyeonggi-do (KR)
(74) Representative: Gulde & Partner

(57) **Abstract**

A display device includes a display panel including pixels, a driving chip electrically connected to the display panel, a cover film covering the driving chip, and a heat dissipation member configured to dissipate heat generated by the driving chip, wherein the heat dissipation member overlaps the cover film in a plan view and includes a transition material having a glass transition temperature less than or equal to a heating temperature of the driving chip.

## Description

### BACKGROUND

### 1. Field

The invention relates to a display device, and more particularly, to a display device that provides visual information.

### 2. Description of the Related Art

As information technology develops, the importance of a display device, which is a connection medium between a user and information, has been emphasized.

The display device includes various components that are driven in response to an electric signal, where the components may generate heat during the driving process and the heat generated by the components may affect the performance of the display device.

### SUMMARY

Embodiments provide a display device with improved heat dissipation.

Additional features of the invention will be set forth in the description which follows, and in part will be apparent from the description, or may be learned by practice of the invention.

In an embodiment, a display device may include a display panel including pixels, a driving chip electrically connected to the display panel, a cover film covering the driving chip, and a heat dissipation member overlapping the cover film in a plan view, wherein the heat dissipation member is configured to dissipate heat generated by the driving chip, and includes a transition material having a glass transition temperature (Tg) that is less than or equal to a heating temperature of the driving chip.

In an embodiment, the transition material may maintain a solid phase at the heating temperature of the driving chip.

In an embodiment, a ratio of a volume of the transition material to a total volume of the heat dissipation member may be about 100 percent.

In an embodiment, the glass transition temperature of the transition material may be in a range of about 25 degrees Celsius to about 80 degrees Celsius, 30 degrees Celsius to 70 degrees Celsius, 45 degrees Celsius to 75 degrees Celsius, 50 degrees Celsius to 60 degrees Celsius, or 55 degrees Celsius to 65 degrees Celsius.

In an embodiment, a modulus of the heat dissipation member may be about 100 megapascals or more, preferably 150 megapascals or more..

In an embodiment, the heat dissipation member may be directly disposed on one surface of the cover film.

In an embodiment, the heat dissipation member may be disposed adjacent to the driving chip.

In an embodiment, at least a portion of the cover film may be spaced apart from one side of the display panel to define an air gap between the cover film and the display panel, where the heat dissipation member may be located within the air gap.

In an embodiment, the display panel may include a first area in which the pixels are disposed, a bending area that is bent with respect to a bending axis, and a second area spaced apart from the first area with the bending area interposed therebetween. The cover film and the heat dissipation member may be disposed in the second area.

In an embodiment, the display device may further include a bending protection layer disposed on the bending area of the display panel. The heat dissipation member may entirely cover the bending protection layer.

In an embodiment, the transition material may include at least one of an acrylic resin or an epoxy resin.

In an embodiment, the acrylic resin may be a polymer derived from a resin composition including a (meth)acrylate monomer, a (meth)acrylate oligomer, and a photoinitiator.

In an embodiment, a glass transition temperature of a homopolymer formed from the (meth)acrylate monomer may be about 100 degrees Celsius or more.

In an embodiment, a content of the (meth)acrylate monomer may be about 20 parts by weight or greater based on a total of 100 parts by weight of the resin composition.

In an embodiment, the epoxy resin may be a polymer derived from a resin composition including an epoxy monomer and a photoinitiator.

In an embodiment a display device may include a display panel including pixels, a metal plate disposed under the display panel, a heat source disposed under the metal plate, and a heat dissipation member disposed between the metal plate and the heat source, wherein the heat dissipation member is configured to dissipate heat generated by the heat source, and includes a transition material having a glass transition temperature (Tg) that is less than or equal to a heating temperature of the heat source.

In an embodiment, the transition material may maintain a solid phase at the heating temperature of the heat source.

In an embodiment, a ratio of a volume of the transition material to a total volume of the heat dissipation member may be about 100 percent.

In an embodiment, the glass transition temperature of the transition material may be in a range of about 25 degrees Celsius to about 80 degrees Celsius.

In an embodiment, a modulus of the heat dissipation member may be about 100 megapascals or more.

In an embodiment, the heat dissipation member may overlap the heat source in a plan view.

In an embodiment, the heat dissipation member may be directly disposed on one surface of the metal plate.

In an embodiment, the heat dissipation member may include a transition material having a glass transition temperature that is less than or equal to a heating temperature of a heat source (e.g., a driving chip or an application processor) that is driven and that generates heat. That is, the transition material may be a material in which a transition, such as a change in arrangement of molecules or mobility, occurs due to the heat generated when the heat source is driven. Accordingly, the heat dissipation member may absorb the heat generated by the heat source. Therefore, the heat dissipation member may improve the heat dissipation of the display device.

In an embodiment, the transition material may be a material in which a phase change, such as liquefaction (melting), does not occur due to the heat generated when the heat source is driven. Accordingly, the heat dissipation member may not include an additional component (e.g., a matrix resin in which the transition material is dispersed or a shell that encapsulates the transition material) for preventing leakage due to liquefaction (melting) of the transition material. According to an embodiment, a ratio of a volume of the transition material to a total volume of the heat dissipation member may increase. Accordingly, a heat absorption efficiency of the heat dissipation member may be improved and the heat dissipation of the display device may be further improved.

It is to be understood that both the foregoing general description and the following detailed description are exemplary and explanatory and are intended to provide further explanation of the invention.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the invention.
FIG. 1 is a plan view illustrating a display device, according to an embodiment.
FIG. 2 is a plan view illustrating an example of the display panel and a circuit board of FIG. 1, according to an embodiment.
FIG. 3 is a cross-sectional view illustrating an example of the display panel of FIG. 1, according to an embodiment.
FIG. 4 is a cross-sectional view taken along a line I-I' of the display device of FIG. 1, according to an embodiment.
FIG. 5 is a cross-sectional view illustrating a state in which the display device of FIG. 1 is bent, according to an embodiment.
FIG. 6 is a plan view illustrating a display device, according to another embodiment.
FIG. 7 is a cross-sectional view illustrating a state in which the display device of FIG. 6 is bent, according to an embodiment.
FIG. 8 is a cross-sectional view illustrating a state in which a display device is bent, according to still another embodiment.
FIG. 9 is a cross-sectional view illustrating a state in which a display device is bent, according to still another embodiment.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being related to another element such as being "on" another element, it can be directly on the other element or intervening elements may be present therebetween. In contrast, when an element is referred to as being related to another element such as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, a reference number may indicate a singular element or a plurality of the element. For example, a reference number labeling a singular form of an element within the drawing figures may be used to reference a plurality of the singular element within the text of specification.

As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the invention.

Illustrative, non-limiting embodiments will be more clearly understood from the following detailed description in conjunction with the accompanying drawings.

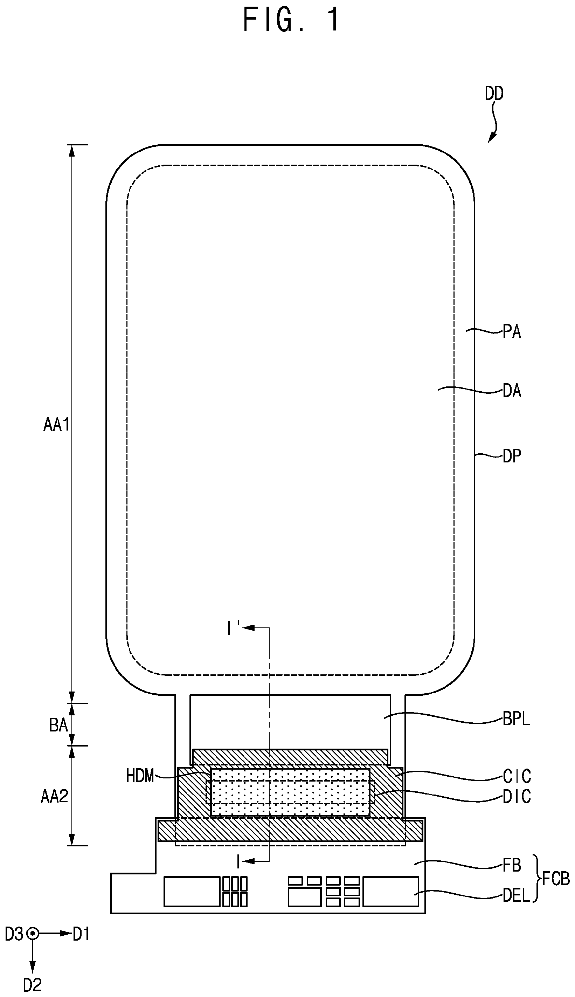

FIG. 1 is a plan view illustrating a display device, according to an embodiment. Specifically, the display device DD of FIG. 1 is in a state before a display panel DP is bent.

In an embodiment and referring to FIG. 1, the display device DD may display an image through a display surface that is directed parallel to a plane defined by a first direction D1 and a second direction D2. The display device DD may display the image in a third direction D3 through the display surface, where the third direction D3 may be directed to be substantially parallel to a normal direction of the display surface. The display surface on which the image is displayed may correspond to a front surface or a top surface of the display device DD.

In an embodiment, the display device DD may include the display panel DP, a driving chip DIC, a circuit board FCB, a bending protection layer BPL, a cover film CIC, and a heat dissipation member HDM.

The display panel DP may be a light emitting display panel, and is not limited to any particular embodiment. For example, the display panel DP may be an organic light emitting display panel, an inorganic light emitting display panel, or a quantum dot light emitting display panel. An emission layer of the organic light emitting display panel may include an organic light emitting material, and an emission layer of the inorganic light emitting display panel may include an inorganic light emitting material. An emission layer of the quantum dot light emitting display panel may include a quantum dot, a quantum rod, or the like. Hereinafter, the display panel DP is described as an organic light emitting display panel.

In an embodiment, the display panel DP may include a first area AA1, a bending area BA, and a second area AA2 arranged along the second direction D2. That is, the bending area BA may extend from the first area AA1 in the second direction D2, and the second area AA2 may extend from the bending area BA in the second direction D2.

The bending area BA may be an area that is bent at a predetermined curvature with respect to a bending axis that extends in the first direction D1. The first area AA1 and the second area AA2 may be flat areas that are not bent. As the bending area BA is bent, the first area AA1 and the second area AA2 may overlap each other in a plan view. That is, by bending the bending area BA, the second area AA2 of the display panel DP may be located on a lower surface of the display panel DP corresponding to the first area AA1.

A width of each of the bending area BA and the second area AA2 in the first direction D1 may be less than a width of the first area AA1 in the first direction D1. As the width of the bending area BA is less in the direction that is parallel to the bending axis, the bending area BA may be easily bent. However, the invention is not limited thereto, and, in another embodiment, the width of the bending area BA in the first direction D1 may be substantially equal to the width of the first area AA1.

In an embodiment, the display panel DP may include a display area DA and a peripheral area PA and may be defined within the first area AA1. The display area DA may be an area that displays the image by generating light or by controlling a transmittance of light provided from an external light source.

The peripheral area PA may be disposed adjacent to the display area DA. For example, the peripheral area PA may surround the display area DA. However, the invention not limited thereto, and, in other embodiments, the peripheral area PA may be defined in various shapes. The peripheral area PA may correspond to an area including a remaining area of the first area AA1 excluding the display area DA, the bending area BA, and the second area AA2. The peripheral area PA may be an area where driving circuits or driving wires for driving elements disposed in the display area DA, various signal lines providing electrical signals to the elements, and pads are arranged.

In an embodiment, the driving chip DIC may be disposed on the second area AA2 of the display panel DP, where the driving chip DIC may be electrically connected to the display panel DP. The driving chip DIC may include driving circuits for driving pixels of the display panel DP, such as a data driving circuit. The driving chip DIC may be manufactured in the form of an integrated circuit chip and may be mounted on the second area AA2 of the display panel DP. The driving chip DIC may be driven and may generate heat. For example, the driving chip DIC may be driven to control driving of the display panel DP and may generate heat during the driving process.

In an embodiment, the circuit board FCB may be disposed adjacent to an end portion of the second area AA2 of the display panel DP, where the circuit board FCB may be spaced apart from the driving chip DIC in the second direction D2. By bending the bending area BA, the circuit board FCB may overlap the first area AA1 of the display panel DP in a plan view.

In an embodiment, the circuit board FCB may be bonded to the display panel DP by a bonding process. For example, the circuit board FCB may be electrically connected to the display panel DP and the driving chip DIC through an anisotropic conductive adhesive layer. The circuit board FCB and the driver chip DIC electrically connected to each other may control driving of the display panel DP.

In an embodiment, the circuit board FCB may include a base film FB and electronic components DEL, where the base film FB may be a flexible circuit film and the electronic components DEL may be mounted on the base film FB. The electronic components DEL may include electronic elements that convert a signal input from an external source into a signal required for the driving chip DIC or into a signal required for driving the display panel DP.

In an embodiment, the bending protection layer BPL may be disposed on the display panel DP, where the bending protection layer BPL may be disposed on the bending area BA. The bending protection layer BPL may be further disposed on a portion of the first area AA1 and a portion of the second area AA2. The bending protection layer BPL may be bent together with the bending area BA, where the bending protection layer BPL may protect the bending area BA from an external impact and may control a neutral plane of the bending area BA.

In an embodiment, the cover film CIC may be disposed on the second area AA2 of the display panel DP and may cover the driving chip DIC. In addition, the cover film CIC may cover one end portion of the circuit board FCB disposed on the second area AA2. In an embodiment, the cover film CIC may cover a portion of the bending protection layer BPL that overlaps a portion of the second area AA2.

The cover film CIC may be a film having conductivity or including a conductive layer, where the cover film CIC may prevent or reduce the driving chip DIC from being damaged by static electricity. In an embodiment, the cover film CIC may be provided in a tape form. That is, the cover film CIC may have an adhesive layer on one surface and may be attached to the second area AA2 of the display panel DP. However, embodiments of the cover film CIC are not limited thereto.

In an embodiment, the heat dissipation member HDM may be disposed on the second area AA2 of the display panel DP, where the heat dissipation member HDM may overlap the cover film CIC in a plan view. For example, the heat dissipation member HDM may be directly disposed on one surface of the cover film CIC. The heat dissipation member HDM may be disposed adjacent to the driving chip DIC. In an embodiment, the heat dissipation member HDM may be configured to dissipate heat generated by the driving chip DIC. For example, the heat dissipation member HDM may absorb heat generated when the driving chip DIC is driven. Accordingly, performance deterioration of the display device DD due to heat generated by the driving chip DIC may be prevented or reduced. The heat dissipation member HDM will be described in more detail below.

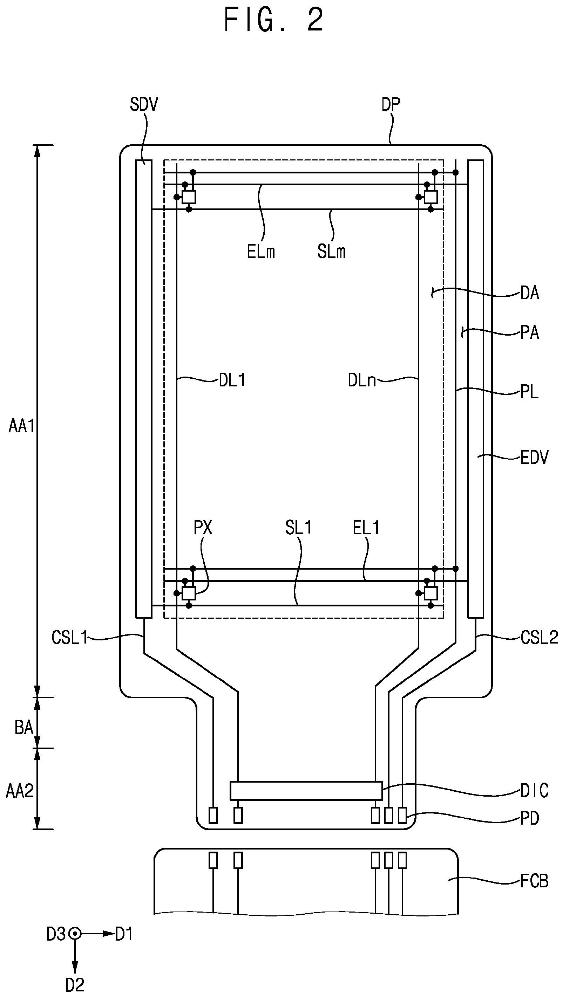

FIG. 2 is a plan view illustrating an example of a display panel and a circuit board of FIG. 1, according to an embodiment. FIG. 2 schematically illustrates some of the components of the display device DD of FIG. 1.

In an embodiment and referring to FIG. 2, the display panel DP may include the first area AA1, the bending area BA, and the second area AA2 arranged along the second direction D2. The display area DA of the display panel DP may be defined within the first area AA1, and the remaining area of the first area AA1 excluding the display area DA, the bending area BA, and the second area AA2 may be defined as the peripheral area PA. The description described above may be substantially equally applied to each of the areas. Therefore, repeated descriptions may be omitted or simplified.

In an embodiment, the display panel DP may include the pixels PX disposed in the display area DA and signal lines SL1-SLm, DL1-DLn, EL1-ELm, CSL1, CSL2, and PL electrically connected to the pixels PX. The display panel DP may include pads PD, a scan driver SDV, and an emission driver EDV disposed in the peripheral area PA.

In an embodiment, each of the pixels PX may include a light emitting element and a pixel driving circuit including transistors (e.g., a switching transistor, a driving transistor, or the like.) connected to the light emitting element and a capacitor. Each of the pixels PX may emit light in response to an electrical signal.

In an embodiment, the signal lines SL1-SLm, DL1-DLn, EL1-ELm, CSL1, CSL2, and PL may include scan lines SL1-SLm, data lines DL1-DLn, emission lines EL1-ELm, a first control line CSL1, a second control line CSL2, and a power line PL, where m and n represent natural numbers. Each of the pixels PX may be connected to a corresponding one of the scan lines SL1-SLm and a corresponding one of the data lines DL1-DLn.

In an embodiment, each of the scan lines SL1-SLm may extend in the first direction D1 and may be connected to the scan driver SDV. Each of the data lines DL1-DLn may extend in the second direction D2 and may be connected to the driving chip DIC via the bending area BA. The emission lines EL1-ELm may extend in the first direction D1 and may be connected to the emission driver EDV.

In an embodiment, the power line PL may extend in the second direction D2 and may be disposed between the display area DA and the emission driver EDV. However, the invention is not limited thereto, and the power line PL may be disposed between the display area DA and the scan driver SDV The power line PL may extend to the second area AA2 via the bending area BA and may be connected to a corresponding one of the pads PD disposed at an end portion of the second area AA2 to receive a voltage. The power line PL may provide a reference voltage to the pixels PX through the connection lines.

In an embodiment, the pads PD may be disposed along one direction on the second area AA2. The pads PD may be disposed adjacent to the end portion of the second area AA2 extending in the first direction D1 and may be arranged along the first direction D1. The pads PD may be portions electrically connected to the circuit board FCB and may be connected to the corresponding ones of the signal lines SL1-SLm, DL1-DLn, EL1-ELm, CSL1, CSL2, and PL.

In an embodiment, the first control line CSL1 may be connected to the scan driver SDV, and the second control line CSL2 may be connected to the emission driver EDV. The control lines CSL1, CSL2 may each extend from the first area AA1 to the second area AA2 via the bending area BA and may be connected to the corresponding ones of the pads PD, respectively. The data lines DL1-DLn may each extend from the first area AA1 to the second area AA2 via the bending area BA and may be connected to the driving chip DIC, where the driving chip DIC may be connected to the pads PD respectively corresponding to the data lines DL1-DLn.

In an embodiment, the circuit board FCB may be connected to the pads PD to control operations of the scan driver SDV, the emission driver EDV, and the driving chip DIC. For example, the circuit board FCB may include output pads respectively corresponding to the pads PD, and the output pads may be respectively electrically connected to the pads PD through the anisotropic conductive adhesive layer. However, the invention is not limited thereto, and a bonding method of the pads PD and the circuit board FCB may include various bonding method such as a soldering method, an ultrasonic bonding method, or the like.

In an embodiment, the scan driver SDV may generate scan signals in response to a scan control signal, where the scan signals may be applied to the pixels PX through the scan lines SL1-SLm. The data driver of the driving chip DIC may generate data voltages corresponding to image signals in response to a data control signal, where the data voltages may be applied to the pixels PX through the data lines DL1-DLn. The emission driver EDV may generate emission signals in response to an emission control signal, where the emission signals may be applied to the pixels PX through the emission lines EL1-ELm.

In an embodiment, the pixels PX may receive the data voltages in response to the scan signals and may display an image by emitting light with a brightness corresponding to the data voltages in response to the emission signals. An emission time of each of the pixels PX may be controlled by the emission signals. The display panel DP may display the image through the display area DA by the pixels PX.

In an embodiment, the signal lines extending from the first area AA1 to the second area AA2 may be disposed on the bending area BA of the display panel DP. As the bending protection layer BPL (see FIG. 1) covers the bending area BA, the bending protection layer BPL may prevent or reduce the signal lines that are disposed on the bending area BA from being damaged by external impact.

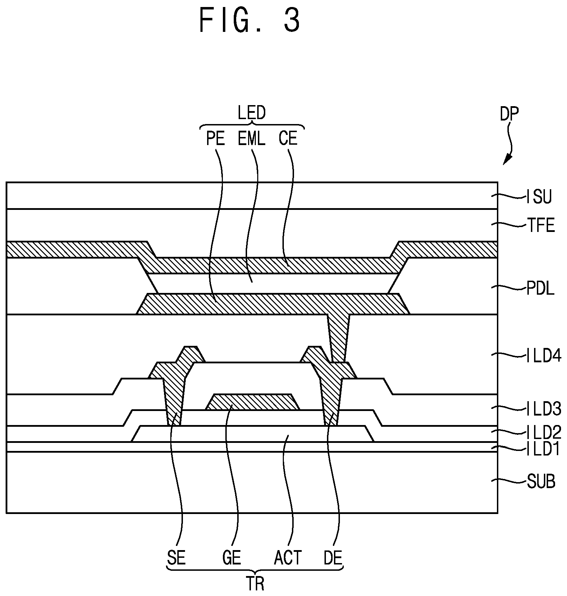

FIG. 3 is a cross-sectional view illustrating an example of the display panel of FIG. 1, according to an embodiment.

In an embodiment and referring to FIG. 3, the display panel DP may include a substrate SUB, a transistor TR, first to fourth insulating layers ILD1, ILD2, ILD3, and ILD4, respectively, a pixel defining layer PDL, a light emitting element LED, an encapsulation layer TFE, and an input sensing layer ISU. For example, the transistor TR may include an active pattern ACT, a gate electrode GE, a first connection electrode SE, and a second connection electrode DE. The light emitting element LED may include a pixel electrode PE, an emission layer EML, and a common electrode CE.

The substrate SUB may include a transparent or opaque material. Examples of materials that can be used as the substrate SUB may include glass, quartz, plastic, or the like. These materials may be used alone or in combination with each other.

The first insulating layer ILD1 may be disposed on the substrate SUB and may prevent or reduce diffusion of metal atoms or impurities to the active pattern ACT from the substrate SUB. In an embodiment, the first insulating layer ILD1 may include an insulating material.

In an embodiment, the active pattern ACT may be disposed on the first insulating layer ILD1 and may include a silicon semiconductor material, an oxide semiconductor material, an organic semiconductor material, or the like. The active pattern ACT may include a source area, a drain area, and a channel area located between the source area and the drain area.

The second insulating layer ILD2 may be disposed on the active pattern ACT and may cover the active pattern ACT. In an embodiment, the second insulating layer ILD2 may include an insulating material.

The gate electrode GE may be disposed on the second insulating layer ILD2 and may overlap the channel area of the active pattern ACT. In an embodiment, the gate electrode GE may include a metal, an alloy, a conductive metal oxide, a transparent conductive material, or the like.

The third insulating layer ILD3 may be disposed on the gate electrode GE and may cover the gate electrode GE. In an embodiment, the third insulating layer ILD3 may include an insulating material.

The first connection electrode SE and the second connection electrode DE may be disposed on the third interlayer insulating layer ILD3, where the first connection electrode SE and the second connection electrode DE may contact the source area and the drain area of the active pattern ACT, respectively. In an embodiment, the first connection electrode SE and the second connection electrode DE may include a metal, an alloy, a conductive metal oxide, a transparent conductive material, or the like.

The fourth insulating layer ILD4 may be disposed on the first connection electrode SE and the second connection electrode DE and may cover the first connection electrode SE and the second connection electrode DE. In an embodiment, the fourth insulating layer ILD4 may include an insulating material.

The pixel electrode PE may be disposed on the fourth insulating layer ILD4 and may include a conductive material such as a metal, an alloy, a conductive metal oxide, a transparent conductive material, or the like.

The pixel electrode PE may be electrically connected to the transistor TR through a contact hole formed in the fourth insulating layer ILD4.

The pixel defining layer PDL may be disposed on the fourth insulating layer ILD4 and the pixel electrode PE and may include an insulating material. The pixel defining layer PDL may define an opening that exposes at least a portion of the pixel electrode PE.

The emission layer EML may be disposed on the pixel electrode PE which is exposed by the opening of the pixel defining layer PDL. In an embodiment, the emission layer EML may have a multi-layer structure including a hole injection layer, a hole transport layer, a light emitting material layer, an electron transport layer, and an electron injection layer.

The common electrode CE may be disposed on the emission layer EML and may include a conductive material such as a metal, an alloy, a conductive metal nitride, a conductive metal oxide, a transparent conductive material, or the like. In an embodiment, the common electrode CE may continuously extend over the pixels on the display area DA.

The encapsulation layer TFE may be disposed on the common electrode CE and may cover the light emitting element LED. The encapsulation layer TFE may prevent or reduce impurities from penetrating into the light emitting element LED. In an embodiment, the encapsulation layer TFE may include at least one organic layer and at least one inorganic layer.

The input sensing layer ISU may be disposed on the encapsulation layer TFE and may sense an external input which may be provided in various forms. For example, in an embodiment, the external input may include user's touch, pen's touch, light, heat, pressure, or the like. In another embodiment, the external input may include a direct contact, and also an input applied an adjacent area (e.g., a hovering). The input sensing layer ISU may include at least one touch electrode and at least one insulating layer. In an embodiment, the input sensing layer ISU may be omitted.

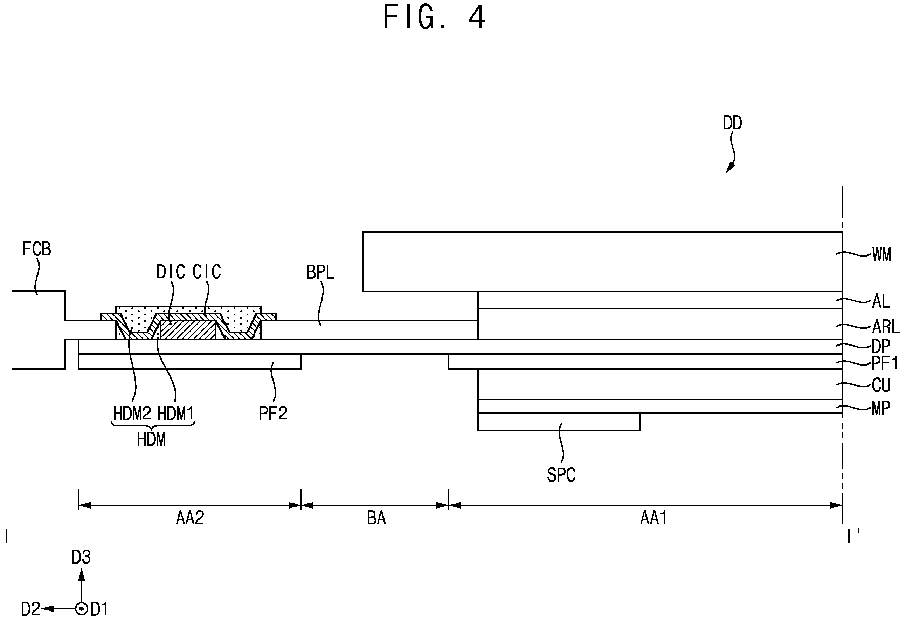

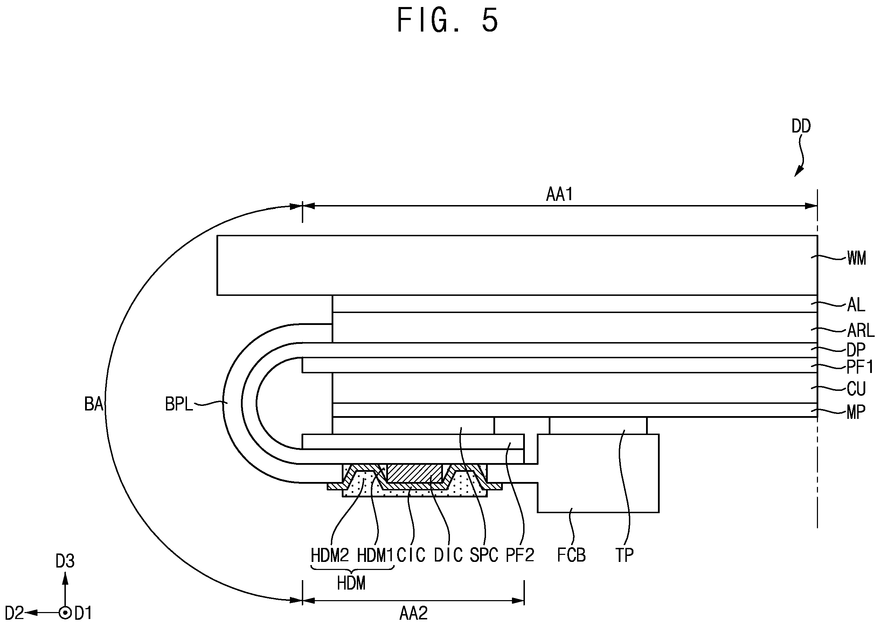

FIG. 4 is a cross-sectional view taken along a line I-I' of FIG. 1, according to an embodiment. FIG. 5 is a cross-sectional view illustrating a state in which the display device of FIG. 1 is bent, according to an embodiment.

The display device DD of FIG. 4 is in a state before the display panel DP is bent, and the display device DD of FIG. 5 is in a state in which the display panel DP is bent. The display device DD may be provided in a state in which the bending area BA of the display panel DP is bent.

In an embodiment and referring to FIGS. 1, 4, and 5, the display device DD may include the display panel DP, an anti-reflection layer ARL, an adhesive layer AL, a window WM, a first protective film PF1, a second protective film PF2, a cushion layer CU, a metal plate MP, a spacer SPC, the bending protection layer BPL, the driving chip DIC, the circuit board FCB, the cover film CIC, and the heat dissipation member HDM. The description described above may be substantially equally applied to the display panel DP, the bending protection layer BPL, the driving chip DIC, the circuit board FCB, the cover film CIC, and the heat dissipation member HDM of FIGS. 4 and 5. Therefore, repeated descriptions may be omitted or simplified.

In an embodiment, the anti-reflection layer ARL and the window WM may be disposed on the display panel DP. For example, the anti-reflection layer ARL may be disposed on the display panel DP, and the window WM may be disposed on the anti-reflection layer ARL.

As such, the window WM may be disposed on the display panel DP and the anti-reflection layer ARL and may prevent or reduce the components of the display device DD from being damaged by an external impact or by scratches applied from an upper side of the window WM.

In an embodiment, the window WM may include an optically transparent material. For example, the window WM may include glass, sapphire, plastic, or the like. The window WM may have a single-layer structure or a multi-layer structure. The window WM may further include a functional layer, such as an anti-fingerprint layer, a phase control layer, or a hard coating layer, disposed on an optically transparent layer.

The anti-reflection layer ARL may reduce a reflectance of external light which is incident from the upper side of the window WM. In an embodiment, the anti-reflection layer ARL may include a retarder and/or a polarizer. The anti-reflection layer ARL may further include a polymer film disposed on the retarder or the polarizer.

In an embodiment, the window WM and the anti-reflection layer ARL may be bonded to each other through the adhesive layer AL, where the adhesive layer AL may be a pressure sensitive adhesive (PSA), an optical clear adhesive (OCA), or an optical clear resin (OCR).

In an embodiment, the first protective film PF1, the second protective film PF2, the cushion layer CU, the metal plate MP, and the spacer SPC may be disposed under the display panel DP. The first protective film PF1, the cushion layer CU, the metal plate MP, and the spacer SPC may be disposed in the first area AA1 and may be sequentially disposed on the lower surface of the display panel DP corresponding to the first area AA1. The second protective film PF2 may be disposed in the second area AA2.

The first protective film PF1 and the second protective film PF2 may be disposed at the substantially same level on the lower surface of the display panel DP. That is, before the bending area BA is bent, the first protective film PF1 and the second protective film PF2 may be disposed side by side in the second direction D2. The first protective film PF1 and the second protective film PF2 may protect the lower surface of the display panel DP and may reinforce an impact resistance of the display panel DP. Additionally, each of the first protective film PF1 and the second protective film PF2 may include an insulating material.

In an embodiment, the first protective film PF1 and the second protective film PF2 may include the same material as each other. The first protective film PF1 and the second protective film PF2 may be formed by removing a portion corresponding to the bending area BA from an integral film covering the entire lower surface of the display panel DP. However, the invention is not limited thereto.

The first protective film PF1 and the second protective film PF2 may be spaced apart from each other with the bending area BA disposed therebetween on the lower surface of the display panel DP. Since the first protective film PF1 and the second protective film PF2 are not disposed in the bending area BA, the bending area BA may be easily bent.

In an embodiment, the cushion layer CU may be disposed under the first protective film PF1 and may relieve pressure applied from a lower side. The cushion layer CU may include foam, sponge, urethane resin, or the like.

In an embodiment, the metal plate MP may be disposed under the cushion layer CU and may include a metal material. For example, the metal plate MP may include copper, nickel, ferrite, silver, or the like, which have excellent thermal conductivity. These metal materials may be used alone or in combination with each other. However, the invention is not limited thereto. Additionally, the metal plate MP may perform an electromagnetic shielding function.

In an embodiment, the spacer SPC may be disposed under the metal plate MP. As illustrated in FIG. 5, in the state in which the bending area BA is bent, the spacer SPC may compensate for a step difference. The spacer SPC may include an insulating material.

In an embodiment, in the state in which the bending area BA is bent, the first protective film PF1, the cushion layer CU, the metal plate MP, the spacer SPC, and the second protective film PF2 may be sequentially disposed between the first area AA1 and the second area AA2 of the display panel DP. The first protective film PF1, the cushion layer CU, the metal plate MP, the spacer SPC, and the second protective film PF2 may be bonded to each other through adhesive layers. However, the invention is not limited thereto, and at least some of the first protective film PF1, the cushion layer CU, the metal plate MP, the spacer SPC, and the second protective film PF2 may be formed by a continuous process without adhesive layers.

Additionally, in the state in which the bending area BA is bent, the circuit board FCB may be bonded to the metal plate MP through a conductive tape TP. That is, the conductive tape TP may compensate for a step difference and may include an anisotropic conductive film, or the like.

As described above, the cover film CIC may be disposed on the second area AA2 of the display panel DP and may cover the driving chip DIC. The cover film CIC may prevent or reduce the driving chip DIC from being damaged by static electricity.

In an embodiment, the cover film CIC may be directly disposed on one surface of the display panel DP. For example, the cover film CIC may have an adhesive layer on one surface and may be attached to an upper surface of the display panel DP corresponding to a second area AA2. In addition, the cover film CIC may cover the one end portion of the circuit board FCB disposed on the second area AA2, and may cover the portion of the bending protection layer BPL overlapping the portion of the second area AA2. Due to a step difference by the circuit board FCB, the driving chip DIC, and the bending protection layer BPL, a portion of the cover film CIC may be spaced apart from one surface (i.e., an upper surface) of the display panel DP to define an air gap between the display panel DP and the cover film.

As described above, the heat dissipation member HDM may be disposed on the second area AA2 of the display panel DP and may overlap the cover film CIC in a plan view. For example, the heat dissipation member HDM may be directly disposed on one surface of the cover film CIC and may be disposed adjacent to the driving chip DIC. Accordingly, the heat dissipation member HDM may be configured to dissipate heat generated by the driving chip DIC. For example, the heat dissipation member HDM may absorb heat generated when the driving chip DIC is being driven.

In an embodiment, the heat dissipation member HDM may include a transition material having a glass transition temperature (Tg) which is less than or equal to a heating temperature of the driving chip DIC. Accordingly, the transition material may transition from a brittle glassy state to a viscous or rubbery state due to the heat generated when the driving chip DIC is being driven. That is, the transition material may be a material in which a transition, such as a change in arrangement of molecules or mobility, occurs due to the heat generated when the driving chip DIC is being driven. In an embodiment, the heating temperature may be a maximum temperature of heat generated when a heat source (e.g., the driving chip DIC) is being driven.

Accordingly, the transition material may absorb heat due to the transition, such as the change in arrangement of molecules or mobility, which occurs due to a temperature increase. That is, the transition of the transition material may occur due to the heat generated when the driving chip DIC is being driven, and at this time, the transition material may absorb a surrounding heat. As a result, the heat dissipation member HDM may absorb the heat generated by the driving chip DIC and may improve the heat dissipation of the display device DD.

In an embodiment, the heating temperature of the driving chip DIC may be in a range of about 40 degrees Celsius to about 80 degrees Celsius. That is, the glass transition temperature of the transition material may be about 80 degrees Celsius or less. In addition, the glass transition temperature of the transition material may be about 25 degrees Celsius or greater. If the glass transition temperature of the transition material is less than about 25 degrees Celsius, the transition may occur at room temperature so that a reliability of the display device DD may decrease.

In an embodiment, the glass transition temperature of the transition material may be less than the heating temperature of the driving chip DIC by a range of about 5 degrees Celsius to about 15 degrees Celsius. In this case, the transition material may more easily absorb the heat generated when the driving chip DIC is being driven. For example, when the heating temperature of the driving chip DIC is about 50 degrees Celsius, the glass transition temperature of the transition material may be in a range of about 35 degrees Celsius to about 45 degrees Celsius. In an embodiment, the glass transition temperature of the transition material may be in a range of about 25 degrees Celsius to about 65 degrees Celsius, preferably, in a range of about 25 degrees Celsius to about 55 degrees Celsius, and more preferably, in a range of about 35 degrees Celsius to about 45 degrees Celsius.

In addition, the transition material may be a material in which a phase change, such as liquefaction (melting), does not occur due to the heat generated when the driving chip DIC is being driven. That is, the transition material included in the heat dissipation member HDM may be in a solid phase and may maintain the solid phase at the heating temperature of the driving chip DIC. In other words, the transition material may not be liquefied (melted) by the heat generated by the driving chip DIC.

As a result, the transition material may have the glass transition temperature less than or equal to the heating temperature of the driving chip DIC, and may maintain the solid phase at the heating temperature of the driving chip DIC. Accordingly, the heat dissipation member HDM may not include an additional component (e.g., a matrix resin in which the transition material is dispersed or a shell that encapsulates the transition material) for preventing leakage due to liquefaction (melting) of the transition material. Therefore, according to an embodiment, a ratio of a volume of the transition material to a total volume of the heat dissipation member HDM may increase. Accordingly, a heat absorption efficiency of the heat dissipation member HDM may be improved and the heat dissipation of the display device DD may be further improved.

For example, in an embodiment, the ratio of the volume of the transition material to the total volume of the heat dissipation member HDM may be about 100 percent. That is, the heat dissipation member HDM may not include a material other than the transition material. For example, the heat dissipation member HDM including the transition material may be formed by a series of processes of applying a resin composition that is polymerized to form the transition material and polymerizing the resin composition.

In an embodiment, the heat dissipation member HDM may have sufficient modulus. That is, the transition material of the heat dissipation member HDM may be a material that implements sufficient modulus of the heat dissipation member HDM. For example, the modulus of the heat dissipation member HDM at about 25 degrees Celsius (room temperature) may be about 100 megapascals or greater. Accordingly, deformation of the heat dissipation member HDM due to an external force may be reduced or prevented and a durability of the display device DD may not be decreased.

In an embodiment, the transition material included in the heat dissipation member HDM may include a polymer material. That is, the heat dissipation member HDM may be formed by curing the polymer material. For example, the heat dissipation member HDM may be formed by photo-curing the polymer material using UV light. However, the invention is not limited thereto.

Examples of the polymer material included in the transition material may include acrylic resin, epoxy resin, or the like. These polymer materials may be used alone or in combination with each other.

In an embodiment, the acrylic resin may be a polymer derived from a resin composition comprising a (meth)acrylate monomer, a (meth)acrylate oligomer, and a photoinitiator, where the (meth)acrylate is a generic term of acrylate and methacrylate.

In an embodiment, the (meth)acrylate monomer included in the acrylic resin may include a monofunctional (meth)acrylate, where the monofunctional (meth)acrylate may include a polar group-containing monofunctional (meth)acrylate monofunctional (meta)acrylate without a polar group.

For example, the polar group-containing monofunctional (meth)acrylate may include, as a polar group: a hydroxy group, an amine group, or a carboxylic group. For example, the polar group may include a hydroxy group, and the monofunctional(meth)acrylate including a hydroxy group as a polar group may include 2-hydroxyethyl(meth)acrylate, 2-hydroxypropyl(meth)acrylate, 4-hydroxybutyl(meth)acrylate, 2-hydroxy-3-phenoxypropyl(meth)acrylate, or a combination thereof. However, the invention is not limited thereto.

For example, examples of the monofunctional (meta)acrylate without a polar group may include methyl(meth)acrylate, ethyl(meth)acrylate, n-propyl(meth)acrylate, isopropyl(meth)acrylate, 1-ethylpropyl(meth)acrylate, 2-ethylpropyl(meth)acrylate, n-butyl(meth)acrylate, sec-butyl(meth)acrylate, isobutyl(meth)acrylate, tert-butyl(meth)acrylate, 1-ethylbutyl(meth)acrylate, 2-ethylbutyl(meth)acrylate, 3-ethylbutyl(meth)acrylate, n-pentyl(meth)acrylate, tert-pentyl(meth)acrylate, neopentyl(meth)acrylate, isopentyl(meth)acrylate, sec-pentyl(meth)acrylate, 3-pentyl(meth)acrylate, sec-isopentyl(meth)acrylate, 1-ethylpentyl(meth)acrylate, 2-ethylpentyl(meth)acrylate, 3-ethylpentyl(meth)acrylate, 4-ethylpentyl(meth)acrylate, n-hexyl(meth)acrylate, isohexyl(meth)acrylate, sec-hexyl(meth)acrylate, tert-hexyl(meth)acrylate, 1-ethylhexyl(meth)acrylate, 2-ethylhexyl(meth)acrylate, 3-ethylhexyl(meth)acrylate, 4-ethylhexyl(meth)acrylate, 5-ethylhexyl(meth)acrylate, n-heptyl(meth)acrylate, isoheptyl(meth)acrylate, sec-heptyl(meth)acrylate, tert-heptyl(meth)acrylate, 1-ethylheptyl(meta)acrylate, 2-ethylheptyl(meth)acrylate, 3-ethylheptyl(meth)acrylate, 4-ethylheptyl(meth)acrylate, 5-ethylheptyl(meth)acrylate, 6-ethylheptyl(meth)acrylate, 7-ethylheptyl(meth)acrylate, n-octyl(meth)acrylate, isooctyl(meth)acrylate, sec-octyl(meth)acrylate, tert-octyl(meth)acrylate, 1-ethyloctyl(meth)acrylate, 2-ethyloctyl(meth)acrylate, 3-ethyloctyl(meth)acrylate, 4-ethyloctyl(meth)acrylate, 5-ethyloctyl(meth)acrylate, 6-ethyloctyl(meth)acrylate, 7-ethyloctyl(meth)acrylate, n-nonyl(meth)acrylate, isononyl(meth)acrylate, sec-nonyl(meth)acrylate, tert-nonyl(meth)acrylate, 1-ethylnonyl(meth)acrylate, 2-ethylnonyl(meth)acrylate, 3-ethylnonyl(meth)acrylate, 4-ethylnonyl(meth)acrylate, 5-ethylnonyl(meth)acrylate, 6-ethylnonyl(meth)acrylate, 7-ethylnonyl(meth)acrylate, 8-ethylnonyl(meth)acrylate, n-decyl(meth)acrylate, isodecyl(meth)acrylate, sec-decyl(meth)acrylate, tert-decyl(meth)acrylate, 1-ethyldecyl(meth)acrylate, 2-ethyldecyl(meth)acrylate, 3-ethyldecyl(meth)acrylate, 4-ethyldecyl(meth)acrylate, 5-ethyldecyl(meth)acrylate, 6-ethyldecyl(meth)acrylate, 7-ethyldecyl(meth)acrylate, or 8-ethyldecyl(meth)acrylate, cyclohexyl(meth)acrylate, isobornyl(meth)acrylate, adamantyl(meth)acrylate, or the like. These may be used alone or in combination with each other. Preferably, the monofunctional (meta)acrylate without a polar group may be adamantyl (meth)acrylate. However, the invention is not limited thereto.

In an embodiment, a glass transition temperature of a homopolymer formed from the (meth)acrylate monomer may be in a range of about 100 degrees Celsius to about 250 degrees Celsius. In this embodiment, a content of the (meth)acrylate monomer may be in a range of about 20 parts by weight to about 95 parts by weight based on a total of about 100 parts by weight of the resin composition. As the resin composition includes the (meth)acrylate monomer satisfying the glass transition temperature described above in the content range described above, a fluidity of the resin composition may be further reduced. Accordingly, a durability of the heat dissipation member HDM formed by curing the resin composition may be further improved.

In an embodiment, the (meth)acrylate monomer included in the acrylic resin may further include a multifunctional (meth)acrylate.

Examples of the (meth)acrylate oligomer included in the acrylic resin may include polyurethane (meth)acrylate oligomer, polyisoprene (meth)acrylate oligomer, polybutadiene (meth)acrylate oligomer, or the like. These may be used alone or in combination with each other.

Examples for the photoinitiator included in the acrylic resin may include a benzophenone-based compound, an anthraquinone-based compound, a benzoin-based compound, an acetophenone-based compound, an α -aminoalkylphenone-based compound, an acylphosphine oxide-based compound, or the like. These may be used alone or in combination with each other.

In an embodiment, the epoxy resin may be a polymer derived from a resin composition comprising an epoxy monomer and a photoinitiator.

Examples of the epoxy monomer included in the epoxy resin may include a commonly used aromatic epoxy resin, an alicyclic epoxy resin, or the like. These may be used alone or in combination with each other. Examples of the aromatic epoxy resin may include a biphenyl-type epoxy resin, a bisphenol A-type epoxy resin, a bisphenol F-type epoxy resin, a phenol novolac-type epoxy resin, a dicyclopentadiene-type epoxy resin, or the like. These may be used alone or in combination with each other.

Examples of the photoinitiator included in the epoxy resin may include an aromatic diazonium salt, an aromatic sulfonium salt, an aromatic iodine aluminum salt, an aromatic sulfonium aluminum salt, a metallocene compound, an iron complex salt, or the like. These may be used alone or in combination with each other.

Examples of the transition materials included in the heat dissipation member HDM are not limited thereto and may include various materials having the glass transition temperature less than or equal to the heating temperature of the driving chip DIC.

In an embodiment, as illustrated in FIGS. 4 and 5, the heat dissipation member HDM may include a first heat dissipation member HDM1 and a second heat dissipation member HDM2. With reference to FIG. 4, the first heat dissipation member HDM1 and the second heat dissipation member HDM2 are illustrated by dividing the heat dissipation member HDM into a portion disposed above the cover film CIC and a portion disposed under the cover film CIC. That is, the description of the heat dissipation member HDM described above may be substantially equally applied to each of the first heat dissipation member HDM1 and the second heat dissipation member HDM2.

In an embodiment, the first heat dissipation member HDM1 may be located within the air gap defined by the cover film CIC and the display panel DP. That is, the first heat dissipation member HDM1 may be located in a space between the cover film CIC and the display panel DP. Accordingly, the first heat dissipation member HDM1 may be covered by the cover film CIC and may be directly disposed on a lower surface of the cover film CIC.

In an embodiment, the first heat dissipation member HDM1 may be directly in contact with the driving chip DIC. Accordingly, the heat generated by the driving chip DIC may be more easily absorbed. However, the invention is not limited thereto, and the first heat dissipation member HDM1 may be spaced apart from the driving chip DIC by a predetermined distance.

The second heat dissipation member HDM2 may be directly disposed on an upper surface of the cover film CIC. In an embodiment, the cover film CIC may have a concave portion due to a step difference caused by the circuit board FCB, the driving chip DIC, and the bending protection layer BPL, and the second heat dissipation member HDM2 may be disposed to fill the concave portion. For example, the second heat dissipation member HDM2 may fill the concave portion and may overlap the driving chip DIC in a plan view. However, the invention is not limited thereto, and the second heat dissipation member HDM2 may be spaced apart from the driving chip DIC in a plan view and may be disposed to correspond to the concave portion. In addition, in an embodiment, the second heat dissipation member HDM2 may be entirely disposed on the upper surface of the cover film CIC. Meanwhile, in another embodiment, the second heat dissipation member HDM2 may be omitted.

In an embodiment, the display device DD may include the heat dissipation member HDM overlapping the cover film CIC in a plan view, and the heat dissipation member HDM may include the transition material having the glass transition temperature which is less than or equal to the heating temperature of the driving chip DIC. That is, the transition material may be a material in which a transition, such as a change in arrangement of molecules or mobility, occurs due to the heat generated when the driving chip DIC is being driven. Accordingly, the heat dissipation member HDM may absorb the heat generated by the driving chip DIC. Therefore, the heat dissipation member HDM may improve the heat dissipation of the display device DD.

In addition, the transition material may be a material in which a phase change, such as liquefaction (melting), does not occur due to the heat generated when the driving chip DIC is being driven. Accordingly, the heat dissipation member HDM may not include an additional component (e.g., a matrix resin in which the transition material is dispersed or a shell that encapsulates the transition material) for preventing leakage due to liquefaction (melting) of the transition material. Therefore, according to an embodiment, the ratio of the volume of the transition material to the total volume of the heat dissipation member HDM may increase. Accordingly, the heat absorption efficiency of the heat dissipation member HDM may be improved and the heat dissipation of the display device DD may be further improved.

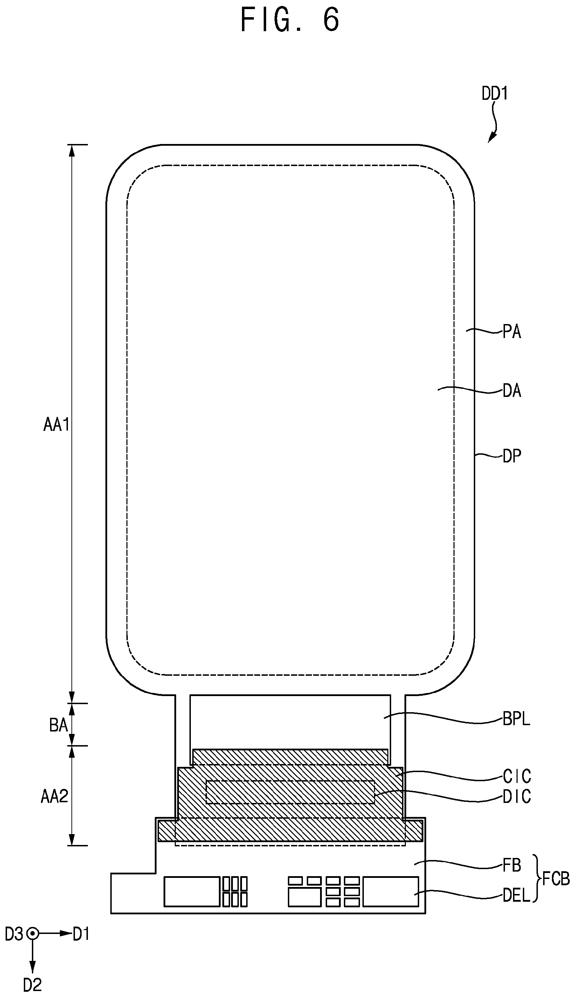

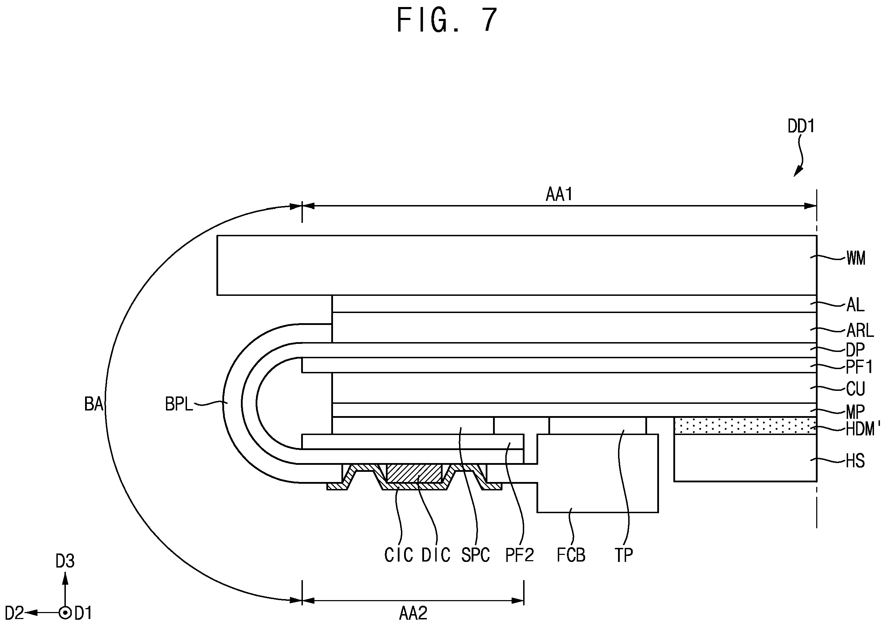

FIG. 6 is a plan view illustrating a display device, according to another embodiment. FIG. 7 is a cross-sectional view illustrating a state in which the display device of FIG. 6 is bent, according to an embodiment.

Specifically, a display device DD1 of FIG. 6 is shown in a state before a display panel DP is bent, and the display device DD1 of FIG. 7 is shown in a state in which the display panel DP is bent. The display device DD1 may be provided in a state in which a bending area BA of the display panel DP is bent.

In an embodiment and referring to FIGS. 6 and 7, the display device DD1 may include the display panel DP, an anti-reflection layer ARL, an adhesive layer AL, a window WM, a first protective film PF1, a second protective film PF2, a cushion layer CU, a metal plate MP, a spacer SPC, a bending protection layer BPL, a driving chip DIC, a conductive tape TP, a circuit board FCB, a cover film CIC, a heat dissipation member HDM', and a heat source HS. The description described above may be substantially equally applied to the display panel DP, the anti-reflection layer ARL, the adhesive layer AL, the window WM, the first protective film PF1, the second protective film PF2, the cushion layer CU, the metal plate MP, the spacer SPC, the bending protection layer BPL, the driving chip DIC, the conductive tape TP, the circuit board FCB, and the cover film CIC of FIGS. 6 and 7. Therefore, repeated descriptions may be omitted or simplified.

In an embodiment, the heat source HS may be disposed on the lower surface of the display panel DP corresponding to the first area AA1. Specifically, the heat source HS may be disposed under the metal plate MP and the heat source HS may be driven and may generate heat. For example, the heat source HS may be an application processor (AP), a direct current-to-direct current converter (DC-DC converter), a built-in battery, or the like. However, the invention is not limited thereto, and the heat source HS is not limited to a particular type as long as it is disposed under the metal plate MP, is driven, and generates heat.

The heat dissipation member HDM' may be disposed on the lower surface of the display panel DP corresponding to the first area AA1. Specifically, the heat dissipation member HDM' may be directly disposed on a lower surface of the metal plate MP. For example, the heat dissipation member HDM' may be disposed between the metal plate MP and the heat source HS. That is, the heat dissipation member HDM' may be disposed on the lower surface of the metal plate MP corresponding to an area where the heat source HS is disposed. In other words, the heat dissipation member HDM' may overlap the heat source HS in a plan view.

Accordingly, in an embodiment, the heat dissipation member HDM' may be disposed adjacent to the heat source HS, where the heat dissipation member HDM' may be configured to dissipate heat generated by the heat source HS. For example, the heat dissipation member HDM' may absorb heat generated when the heat source HS is being driven. Accordingly, performance deterioration of the display device DD1 due to heat generated by the heat source HS may be prevented or reduced.

In an embodiment, the heat dissipation member HDM' may include a transition material having a glass transition temperature (Tg) that is less than or equal to a heating temperature of the heat source HS. Accordingly, the transition material may transition from a brittle glassy state to a viscous or rubbery state due to the heat generated when the heat source HS is being driven. That is, the transition material may be a material in which a transition, such as a change in arrangement of molecules or mobility, occurs due to the heat generated when the heat source HS is being driven.

As a result, the transition material included in the heat dissipation member HDM' may absorb heat due to the transition, such as the change in arrangement of molecules or mobility, which is occurred by a temperature increase. That is, the transition of the transition material may occur due to the heat generated when the heat source HS is being driven, and at this time, the transition material may absorb a surrounding heat. Accordingly, the heat dissipation member HDM' may absorb the heat generated by the heat source HS. Therefore, the heat dissipation member HDM' may improve a heat dissipation of the display device DD1.

In an embodiment, the heating temperature of the heat source HS may be in a range of about 40 degrees Celsius to about 80 degrees Celsius. That is, the glass transition temperature of the transition material may be about 80 degrees Celsius or less. In addition, the glass transition temperature of the transition material may be about 25 degrees Celsius or greater. If the glass transition temperature of the transition material is less than about 25 degrees Celsius, the transition may occur at room temperature so that a reliability of the display device DD1 may decrease.

Preferably, the glass transition temperature of the transition material may be less than the heating temperature of the heat source HS by a range of about 5 degrees Celsius to about 15 degrees Celsius. In this case, the transition material may more easily absorb the heat generated when the heat source HS is being driven. For example, when the heating temperature of the heat source HS is about 50 degrees Celsius, the glass transition temperature of the transition material may be in a range of about 35 degrees Celsius to about 45 degrees Celsius. In an embodiment, the glass transition temperature of the transition material may be in a range of about 25 degrees Celsius to about 65 degrees Celsius, and preferably, in a range of about 25 degrees Celsius to about 55 degrees Celsius, and more preferably, in a range of about 35 degrees Celsius to about 45 degrees Celsius.

In addition, the transition material may be a material in which a phase change, such as liquefaction (melting), does not occur due to the heat generated when the heat source HS is being driven. That is, the transition material included in the heat dissipation member HDM' may be in a solid phase and may maintain the solid phase at the heating temperature of the heat source HS. In other words, the transition material may not be liquefied (melted) by the heat generated by the heat source HS.

As a result, the transition material may have the glass transition temperature that is less than or equal to the heating temperature of heat source HS, and may maintain the solid phase at the heating temperature of heat source HS. Accordingly, the heat dissipation member HDM' may not include an additional component (e.g., a matrix resin in which the transition material is dispersed or a shell that encapsulates the transition material) for preventing leakage due to liquefaction (melting) of the transition material. According to an embodiment, a ratio of a volume of the transition material to a total volume of the heat dissipation member HDM' may increase. Accordingly, a heat absorption efficiency of the heat dissipation member HDM' may be improved and the heat dissipation of the display device DD1 may be further improved.

For example, in an embodiment, the ratio of the volume of the transition material to the total volume of the heat dissipation member HDM' may be about 100 percent. That is, the heat dissipation member HDM' may not include a material other than the transition material. For example, the heat dissipation member HDM' including the transition material may be formed by a series of processes of applying a resin composition that is polymerized to form the transition material and by polymerizing the resin composition.

In an embodiment, the heat dissipation member HDM' may have sufficient modulus. That is, the transition material of the heat dissipation member HDM' may be a material that implements sufficient modulus of the heat dissipation member HDM'. For example, the modulus of the heat dissipation member HDM' at about 25 degrees Celsius (room temperature) may be about 100 megapascals or greater. Accordingly, deformation of the heat dissipation member HDM' due to an external force may be reduced or prevented and a durability of the display device DD1 may not be decrease.

The transition material included in the heat dissipation member HDM' may include a polymer material. The description of the polymer material included in the heat dissipation member HDM described above with reference to FIGS. 1, 4, and 5 may be substantially equally applied to the polymer material included in the transition material. Therefore, repeated descriptions may be omitted.

In an embodiment, the display device DD1 may include the heat dissipation member HDM' disposed between the metal plate MP and the heat source HS, and the heat dissipation member HDM' may include the transition material having the glass transition temperature that is less than or equal to the heating temperature of the heat source HS. That is, the transition material may be a material in which a transition, such as a change in arrangement of molecules or mobility, occurs due to the heat generated when the heat source HS is being driven. Accordingly, the heat dissipation member HDM' may absorb the heat generated by the heat source HS. Therefore, the heat dissipation member HDM' may improve the heat dissipation of the display device DD1.

In addition, the transition material may be a material in which a phase change, such as liquefaction (melting), does not occur due to the heat generated when the heat source HS is being driven. Accordingly, the heat dissipation member HDM' may not include an additional component (e.g., a matrix resin in which the transition material is dispersed or a shell that encapsulates the transition material) for preventing leakage due to liquefaction (melting) of the transition material. Therefore, according to an embodiment, the ratio of the volume of the transition material to the total volume of the heat dissipation member HDM' may increase. Accordingly, the heat absorption efficiency of the heat dissipation member HDM' may be improved and the heat dissipation of the display device DD1 may be further improved.

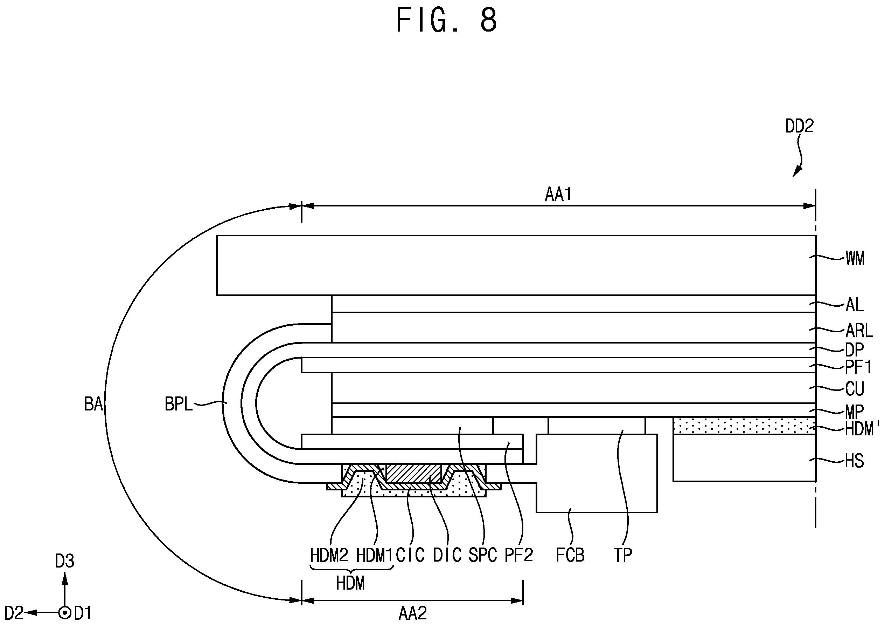

FIG. 8 is a cross-sectional view illustrating a state in which a display device is bent, according to still another embodiment.

In an embodiment and referring to FIG. 8, a display device DD2 may be substantially the same as the display device DD1 described with reference to FIGS. 6 and 7 with the exception that the display device DD2 further includes the heat dissipation member HDM. Therefore, repeated descriptions may be omitted.

That is, the display device DD2 may include both the heat dissipation member HDM for absorbing the heat generated when the driving chip DIC is driven and the heat dissipation member HDM' for absorbing the heat generated when the heat source HS is driven. Accordingly, a heat dissipation of the display device DD2 may be further improved.

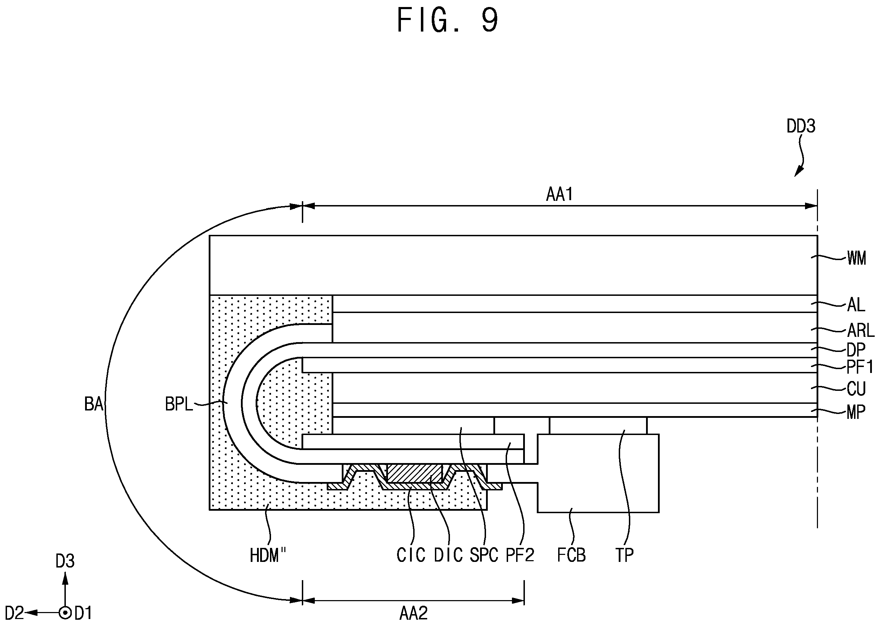

FIG. 9 is a cross-sectional view illustrating a state in which a display device is bent, according to still yet another embodiment.

In an embodiment and referring to FIG. 9, a display device DD3 may be substantially the same as the display device DD described with reference to FIGS. 1, 4, and 5 with the exception that the heat dissipation member HDM (see FIGS. 4 and 5) is replaced with a heat dissipation member HDM", where the heat dissipation member HDM" may be substantially the same as the heat dissipation member HDM except for an arrangement form. Therefore, repeated descriptions may be omitted.

In an embodiment, the display device DD3 may include the heat dissipation member HDM" which may entirely cover the bending protection layer BPL and may overlap the cover film CIC in a plan view. That is, the heat dissipation member HDM" may completely cover the bending protection layer BPL that is bent at a predetermined curvature. For example, the heat dissipation member HDM" may be disposed along an outer edge of the display device DD3 provided in a bent state, and may be integrally provided to entirely cover the bending protection layer BPL and overlap the cover film CIC in a plan view.

That is, in the display device DD3, according to an embodiment, the heat dissipation member HDM" may function as a molding part that determines a shape of a frame of the display device DD3. The molding part may be an outer frame of the display device DD3 and may contact a set bracket surrounding the display device DD3. That is, the display device DD3 may have a structure in which the heat dissipation member HDM" for dissipating heat generated by the driving chip DIC functions as the molding part. Therefore, the display device DD3 may have a more simplified structure.

The foregoing is illustrative of the present invention and is not to be construed as limiting thereof. Although a few embodiments of the invention have been described, those skilled in the art will readily appreciate that many modifications of the invention are possible without materially departing from the scope and the novel teachings and advantages of the invention. Accordingly, all such modifications are intended to be included within the scope of the invention. Therefore, it is to be understood that the foregoing is illustrative of the invention and is not to be construed as limited to the specific embodiments disclosed herein which are intended to be included within the scope of the invention. Moreover, the invention or parts of the invention may be combined in whole or in part without departing from the scope of the invention.

## Claims

1. A display device comprising:
a display panel (DP) including pixels;
a driving chip (DIC) electrically connected to the display panel;
a cover film (CIC) covering the driving chip; and
a heat dissipation member (HDM, HDM', HDM'') configured to dissipate heat generated by the driving chip,
wherein the heat dissipation member (HDM, HDM', HDM'') overlaps the cover film in a plan view and includes a transition material having a glass transition temperature less than or equal to a heating temperature of the driving chip.

2. The display device of claim 1, wherein the transition material maintains a solid phase at the heating temperature of the driving chip.

3. The display device of claim 1 or 2, wherein a ratio of a volume of the transition material to a total volume of the heat dissipation member (HDM, HDM', HDM'') is 00 percent.

4. The display device of any of the preceding claims, wherein the glass transition temperature of the transition material is in a range of 25 degrees Celsius to 80 degrees Celsius.

5. The display device of any of the preceding claims, wherein a modulus of the heat dissipation member (HDM, HDM', HDM'') is 100 megapascals or greater.

6. The display device of any of the preceding claims, wherein the heat dissipation member (HDM, HDM', HDM'') is directly disposed on one surface of the cover film (CIC).

7. The display device of any of the preceding claims, wherein the heat dissipation member (HDM, HDM', HDM'') is disposed adjacent to the driving chip.

8. The display device of any of the preceding claims, wherein at least a portion of the cover film (CIC) is spaced apart from one side of the display panel to define an air gap between cover film (CIC) and the display panel, and
wherein the heat dissipation member (HDM, HDM', HDM") is located within the air gap.

9. The display device of any of the preceding claims, wherein the display panel includes:
a first area (AA1) in which the pixels are disposed;
a bending area (BA) that is bent with respect to a bending axis; and
a second area (AA2) that is spaced apart from the first area (AA1) with the bending area interposed therebetween,
wherein the cover film (CIC) and the heat dissipation member (HDM, HDM', HDM") are disposed in the second area.

10. The display device of claim 9, further comprising:
a bending protection layer (BPL) disposed on the bending area, and
wherein the heat dissipation member (HDM, HDM', HDM'') entirely covers the bending protection layer.

11. The display device of any of the preceding claims, wherein the transition material comprises at least one of an acrylic resin and an epoxy resin.

12. The display device of claim 11, wherein the acrylic resin is a polymer derived from a resin composition comprising a (meth)acrylate monomer, a (meth)acrylate oligomer, and a photoinitiator.

13. The display device of claim 12, wherein a glass transition temperature of a homopolymer formed from the (meth)acrylate monomer is 100 degrees Celsius or greater.

14. The display device of claim 12 or 13, wherein a content of the (meth)acrylate monomer is 20 parts by weight or greater based on a total of 100 parts by weight of the resin composition.

15. The display device of claim 11, wherein the epoxy resin is a polymer derived from a resin composition comprising an epoxy monomer and a photoinitiator.
